# EUROPEAN PATENT SPECIFICATION

(11) **EP 2 625 722 B1**
(45) Date of publication and mention of the grant of the patent: **12.02.2020**
(21) Application number: 11831127.3
(22) Date of filing: 26.08.2011
(51) Int. Cl.: H01L 31/18, H01L 31/0216, H01L 31/042, H01B 1/02, H01B 1/22, C23C 18/16, C08K 3/08

(54) **CU PASTE METALLIZATION FOR SILICON SOLAR CELLS**
CU-PASTEN-METALLISIERUNG FÜR SILICIUMSOLARZELLEN
MÉTALLISATION PAR PÂTE DE CUIVRE POUR CELLULES SOLAIRES AU SILICIUM

(30) Priority: 16.08.2011 US 201113211180; 05.10.2010 US 390080 P
(43) Date of publication of application: 14.08.2013
(73) Proprietor: Applied Materials, Inc., Santa Clara, CA 95054 (US)
(72) Inventor: GEE, James, M., Albuquerque New Mexico 87122 (US)
(74) Representative: Zimmermann & Partner Patentanwälte mbB
(86) International application number: PCT/US2011/049359
(87) International publication number: WO 2012/047404

(56) References cited:
- WO-A1-2009/052461
- WO-A1-2009/108675
- US-A- 4 612 410
- US-A1- 2007 145 507
- US-A1- 2009 096 100
- US-A1- 2009 126 797

## Description

### BACKGROUND OF THE INVENTION

### Field of the Invention

Embodiments of the invention relate to a contact structure for a solar cell device. In particular, embodiments of the invention relate to copper contact structures formed using copper metallization pastes.

### Description of the Related Art

Conventional silicon solar cells, such as crystalline-silicon solar cells, primarily use a silver-based metallization for the front-surface current-collection grid and for the rear-surface contacting areas. The silver is applied in a paste format by screen printing. The conventional silver pastes may consist of silver particles and glass frit particles mixed with an organic resin. The organic resins are required as a carrier for the printing process. Other organic chemicals may be added to tune the viscosity of the paste and to help keep the inorganic particles in suspension. The glass frit particles soften during heating, such as during a "firing" step (a short high-temperature anneal) to hold the silver particle matrix together and to the silicon substrate, and to facilitate the formation of a low contact resistance metal contact on the surface of the silicon solar cell. The organic resins are generally burned off during the firing step. The resulting metallization is an inhomogeneous mixture of silver, glass, and voids.

Printable silver-based metallizations for silicon solar cells have the following advantages: direct patterning technology for low cost manufacturing, ability to be fired in oxidizing ambient for low cost and to allow oxidation of organic carriers, and good electrical conductivity. Moreover, silver is a fairly benign metallic impurity in silicon. However, a significant disadvantage of silver-based metallization is the cost of silver. It would be highly advantageous to replace silver with a less expensive metal that is also conductive. Additionally, the annealing atmosphere of pastes with non-precious metals may use expensive inert and non-reactive compounds, and the sintering process may require long times and high temperatures, which also increases manufacturing expenses and may reduce solar cell efficiency.

Copper has been proposed to replace silver, but current copper deposition processes using electrochemical processes are difficult to integrate into current solar cell manufacturing processes and may create other problems. For example, electrochemical processes require very aggressive chemicals, expensive waste treatment, and additional steps for patterning. Making electrical contact with the often very thin solar cell substrates during an electrochemical deposition processes is problematic because the substrates are so fragile. Moreover, the yield for thin-film deposition techniques is low due to the tendency for metal to deposit everywhere and not in the desired substrate surface locations. These copper deposition techniques are often more expensive than screen printing and required additional steps for patterning the deposited copper. As these processes are also completely different from current production practices, they cannot be integrated easily into current production lines.

A conductive paste and a grid electrode for silicon solar cells is described in WO 2009/108675 A1. Therein, core-shell particles are used in addition to silver particles, wherein a specific metal selected from the group consisting of Pd, Ir, Pt, Ru, Ti and Co is coated on the surface of silver or copper.

Therefore, a need exists for improved copper contact structures, copper metallization materials, and methods of forming copper contact structures for solar cell devices.

### SUMMARY OF THE INVENTION

In one embodiment of the invention, a copper metallization paste includes an organic matrix, glass frits within the organic matrix, and a metal powder within the organic matrix, the metal powder comprising encapsulated copper-containing particles, wherein the encapsulated copper-containing particles each further include a copper-containing particle and at least two coatings of different materials surrounding the copper-containing particle, wherein each coating includes a material selected from the group consisting of silver (Ag), nickel (Ni), zinc (Zn), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

In another embodiment, a solar cell includes a substrate comprising a doped semiconductor material and a front contact structure on a portion of a front surface of the substrate, wherein the front contact structure includes a copper layer comprising sintered encapsulated copper-containing particles, wherein at least some of the encapsulated copper-containing particles further include a copper-containing particle and multiple coatings of different materials surrounding the copper-containing particle, wherein each coating comprises a material selected from the group consisting of nickel (Ni); zinc (Zn); nickel (Ni) and at least one of titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof; zinc (Zn) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, and transition metal silicide alloys their alloys, or combinations thereof; and silver (Ag) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

In another embodiment, a method of forming a contact structure on a solar cell includes depositing a copper metallization paste on a substrate comprising a doped semiconductor material and heating the copper metallization paste to form a copper layer. The copper metallization paste includes an organic matrix, glass frits within the organic matrix, and a metal powder within the organic matrix, the metal powder comprising encapsulated copper-containing particles, wherein at least some of the encapsulated copper-containing particles further include a copper-containing particle and at least two coatings of different materials surrounding the copper-containing particle, wherein each coating includes a material selected from the group consisting of silver (Ag), nickel (Ni), zinc (Zn), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

### BRIEF DESCRIPTION OF THE DRAWINGS

So that the manner in which the above-recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a plan view of a front surface, or light receiving surface, of a solar cell substrate.
Figures 2A-2C are cross-sectional views of encapsulated copper-containing particles for forming copper metallization materials.
Figure 3 illustrates a schematic cross-sectional view of a copper conductive layer matrix after sintering.
Figure 4A is a schematic cross-sectional view of a portion of a solar cell substrate having a copper second layer printed on a first layer.
Figure 4B is a schematic cross-sectional view of a portion of a solar cell substrate having a copper second layer printed on a first layer including buss lines.
Figure 5A is a schematic cross-sectional view of a portion of a solar cell having a copper layer printed on the solar cell substrate.
Figure 5B is a close up of the copper layer printed on the solar cell substrate as shown in Figure 5A.
Figure 6 illustrates a schematic cross-sectional view of a copper metallization structure for an ink-jet process.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

The invention generally provides methods of forming contact structures, sometimes referred to as grids or gridlines, on surfaces of solar cell devices. In particular, embodiments of the invention provide methods, structures, and materials for forming copper-containing contact structures using printing methods such as screen printing. In some embodiments, screen printing processes are used to form a contact structure on the front or back-side of a solar cell device. Most crystalline-silicon solar cell devices having contact structures formed on one or more surfaces of a solar cell device, such as those used in back contact solar cells devices or emitter wrap through (EWT) solar cell devices, may benefit from one or more of the embodiments described herein. Embodiments of the invention can be used to form contact structures on back contact type solar cells, although front side contact structures are the only types shown to illustrate embodiments of the invention.

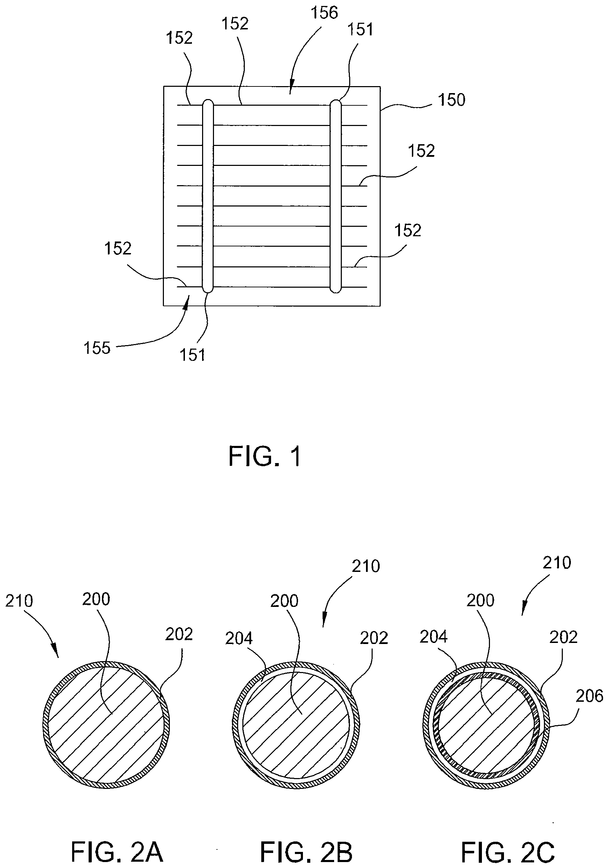

Figure 1 is a plan view of a front surface 155, or light receiving surface, of a solar cell substrate 150. The solar cell substrate 150 may comprise a doped semiconductor material. For example, the solar cell substrate 150 may be a p-type doped bulk silicon substrate having an n-type doped layer or layers to form p-n junctions in the solar cell substrate 150. Electrical current generated by the junction formed in a solar cell when illuminated flows through a front contact structure 156 disposed on the front surface 155 of the solar cell substrate 150 and a back contact structure (not shown) disposed on the back surface (not shown) of the solar cell substrate 150. The front contact structure 156, as shown in Figure 1, may be configured as widely-spaced thin metal lines, or fingers 152, that supply current to bus bars 151 larger than the fingers 152. Typically, the front surface 155 is coated with a thin layer of dielectric material, such as silicon nitride (SiNₓ), which may act as an antireflection coating (ARC) to minimize light reflection as well as a passivation layer to decrease recombination losses. The dielectric material is disposed in between parts of the front contact structure 156 so that both the dielectric material and the contact structure 156 are on the front surface 155 of the solar cell substrate 150.

A screen printing device may be used to form buss bars 151 and fingers 152 on the front surface 155 of the solar cell substrate 150. Screen printing methods generally provide a simple process for forming particular patterns and thicknesses of contact structure, and enable using a variety of layers and/or materials to form the contact structure. The screen printing device is generally a sheet or plate contained in a screen printing chamber that has a plurality of holes, slots, or other features formed therein to define the pattern and placement of screen printed paste on the front surface 155 of the solar cell substrate 150. Multiple layers may be "printed" on the front surface 155 to form the front contact structure 156. A back contact structure may also be formed by similar methods.

Conventional front contact structures 156 are typically formed by printing a silver paste on the front surface 155 of the solar cell substrate 150. However, in one embodiment of the invention, a copper metallization paste is used to form the front contact structure 156. Although the cost of silver metallization paste fluctuates with the price of silver, silver tends to be an expensive precious metal which results in the silver metallization paste also being expensive. One alternative to using silver as the conductive material for a contact structure is to use copper.

Copper is a good conductor like silver, but it also has many drawbacks. Copper can poison silicon when it comes in contact with a silicon substrate, thereby rendering a solar cell device made from a silicon substrate ineffectual. Copper diffuses rapidly within silicon at typical operational temperatures for photovoltaic modules, where it is an active recombination center that can affect the solar cell's efficiency. Once copper diffuses into polymeric materials and solar cell structures, it causes problems. Additionally, copper oxidizes easily, which can affect its ability to make electrical contact with other current carrying features connected to the solar cell. Solar cell device processing is therefore more difficult since oxidation must be prevented and/or the amount of oxidation must be controlled. Copper will oxidize in the module if moisture is not excluded, which can cause reliability and aesthetic issues. Moreover, the most common solar cell device encapsulant material, ethyl vinyl acetate (EVA), will photodegrade if it comes into contact with copper.

Embodiments of the invention provide a copper metallization system that is compatible with current print technologies such as screen printing, etc. Embodiments of the invention include copper metallization pastes that overcome some of the problems associated with using copper metal contacts in solar cell devices, and enable screen printing of copper based contact structures. A copper metallization paste may be formed using copper-containing particles that are encapsulated with one or more materials to form a coating thereon. As used herein, layer refers to a coating, and coatings can include a single coating, or multiple coatings, either of which may include a single material or multiple materials. The coatings may form a layered structure surrounding the copper-containing particles, which particle thus forms a core surrounded by one or more coatings or layers.

The term coating may include a single coating, multiple coatings, and various layers that surround a core, depending on context. A layer or a coating surrounds or coats a core. The materials for the coatings or layers may be chosen for their various characteristics, properties, and/or qualities. For example, the materials may be selected for and applied as various types of barrier layers having desired barrier properties. Some of the barrier layers may include oxidation barrier layers to prevent and/or reduce oxidation of the core material, metallization barrier layers to prevent and/or reduce undesired alloying of a material with the core material, and diffusion barrier layers to prevent and/or reduce the diffusion of the copper based core material into the adjacent substrate and structures thereon. Thus, the different barrier layers are applied as a coating and the coating functions as one or more types of barrier layers. Figures 2A-2C are cross-sections of some different types of encapsulated copper-containing particles 210 used that form part of the copper metallization pastes used to form contact structures in solar cell devices and modules.

The copper-containing particle may include copper, doped copper, or copper alloys. Various types of dopants in copper may be used such as aluminum, magnesium, or other elements that enable doped copper to oxidize less rapidly compared to pure copper. Various copper alloys may be used for the copper-containing particle depending on ease of fabrication, desired physical properties, e.g. hardness, and reduced tendency to oxidize. For example, some copper alloys may include Cu:Sn, Cu:Ag, Cu:Ni, Cu:Zn, or combinations thereof. The copper-containing particles may vary in size between 0.001 and 1,000 microns, such as from about .01 to 50 microns or about 1 to 20 microns. The desired size of the copper-containing particles may depend on the method used for applying the copper metallization paste to a substrate.

Contact structures and other types of metallic connections in solar cell devices and modules are typically exposed to heating processes, such as sintering and firing processes, during solar cell device and/or solar cell module manufacturing processes. The outermost layer of an encapsulated copper-containing particle 210 may comprise an oxidation barrier layer 202 so that the copper metallization paste can be fired in an oxidizing ambient. Thus, an inert ambient, such as nitrogen or argon which tend to be more expensive than an oxidizing ambient, is not required when firing the copper metallization paste. For example, oxidation barrier layer 202 encapsulates a copper-containing particle 200 as shown in Figure 2A. The oxidation barrier layer 202 may be any metal that forms a thin, stable oxide that dissolves in a glass frit. The oxidation barrier layer 202 may include silver (Ag), nickel (Ni), and zinc (Zn), their alloys, or combinations thereof. The oxidation barrier layer 202 may be between 0.01 and 10 microns thick, such as between 0.1 to 2 microns, for example greater than 1.0 microns.

The oxidation barrier layer facilitates solar cell device processing and prevents solar cell and solar module degradation in the finished product. In the embodiments using silver as the oxidation barrier layer, a thin silver layer may be used when using a single barrier layer to form an encapsulated copper-containing particle 210 in a copper metallization paste for forming a contact structure. Hence, a paste using silver-coated copper-containing particles may be chemically and metallurgically similar to silver metallization pastes currently in use, thereby providing a similar metal contact between the paste and the silicon surface as conventional metallization structures, but at a lower cost by using copper with small amounts of silver.

Figure 2B shows another embodiment of the invention where the copper-containing particle 200 is encapsulated with a metallization barrier layer 204. The metallization barrier layer 204 provides a layer that remains stable up through the firing temperatures to prevent any copper in the copper-containing particle 200 from alloying with the oxidation barrier layer 202. For example, if the oxidation barrier layer 202 is silver, the eutectic point temperature of an Ag-Cu alloy is around 790 °C, which means that as firing temperatures rise above the Ag-Cu eutectic point, portions of the silver layer and copper from the copper-containing particle will become molten, and the copper material will form an alloy with the silver material. The metallization barrier layer 204 thus provides a stable layer between the silver based oxidation barrier layer 202 and the copper in the copper-containing particle 200 to prevent partial alloying of copper with silver along the interface between the two materials.

The metallization barrier layer 204 includes metals and alloys with a high liquidus point relative to copper to maintain separation between the copper-containing particle 200 and the oxidation barrier layer 202. The metallization barrier layer may include nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), their alloys, or combinations thereof. In some embodiments, a dielectric material may be used as the metallization barrier layer, such as glass. The metallization barrier layer 204 may be between 0.01 and 10 microns thick, such as between 0.1 to 2 microns, for example greater than 1.0 microns.

Figure 2C illustrates another embodiment of the invention where the copper-containing particle 200 is encapsulated with an oxidation barrier layer 202, a metallization barrier layer 204, and a diffusion barrier layer 206. Trace amounts of copper may still out-diffuse through the various barrier layers and into neighboring silicon substrates by solid state diffusion, though the amount may be relatively low. The diffusion barrier layer 206 provides an additional protective layer to prevent, or at least greatly limit, any copper diffusion through the barrier layers 202, 204 and into the solar cell device and the rest of a solar cell module package. The diffusion barrier layer 206 may directly surround the copper-containing particle 200 and the metallization barrier layer 204 may directly surround the diffusion barrier layer 206, as shown in Figure 2C. Alternatively, the metallization barrier layer 204 may directly surround the copper-containing particle 200 and the diffusion barrier layer 206 may directly surround the metallization barrier layer 204. The diffusion barrier layer may include nickel (Ni), titanium (Ti), titanium nitride (TiN), transition metal nitrides, transition metal silicide alloys, tungsten (W), titanium-tungsten (TiW), tungsten doped cobalt (Co:W), cobalt (Co), molybdenum (Mo), tantalum (Ta), and chromium (Cr), their alloys, or combinations thereof. The diffusion barrier layer 206 may be between 0.01 and 10 microns thick, such as between 0.1 to 2 microns, for example greater than 1.0 microns.

In some embodiments, the metallization barrier layer 204 and diffusion barrier layer 206 may be combined into a single layer exhibiting properties of both layers. For example, metallization barrier layer 204 that is nickel based may also exhibit sufficient diffusion barrier properties, such that the metallization barrier layer also acts as a diffusion barrier layer. In some configurations, the copper-containing particles are individually coated with the multiple barrier layers as appropriate for the type of copper encapsulated particle desired. Thus, the copper-containing particles may be coated with a first barrier layer, a second barrier layer, a third barrier layer, or more barrier layers as desired. In some embodiments, the copper-containing particle 200 may be surrounded by at least one barrier layer, for example an oxidation barrier layer 202. In other embodiments, the copper containing particle 200 may be surrounded by at least two barrier layers, for example an oxidation barrier layer 202 and a metallization barrier layer 204 or a diffusion barrier layer 206. The oxidation barrier layer 202, the metallization barrier layer 204, and the diffusion barrier layer 206 may be formed by using electroless plating, electroplating, chemical vapor deposition, chemical solution deposition, or combinations of the techniques.

The copper metallization paste formulation may be like standard screen-printable pastes and may include various constituent components for formulating the desired properties of the copper metallization paste. The constituent components may include metal powder, glass frits, and an organics package or matrix. The metal powder, which would include the encapsulated copper-containing particles described herein, may be chosen by type of alloy composition, size distribution, and shape, for example a spherical shape, flakes, etc.

The copper metallization paste may include other metal powders in addition to the copper metal powder materials. These metals may provide better flow and bonding properties compared to the encapsulated copper particles to facilitate the fusion of the metal particles during heating, such as firing or sintering. For example, the copper paste could include Ag particles that have firing characteristics that are known to be compatible with silicon solar cell fabrication.

Glass frits may also be added to the copper metallization paste. Glass frits liquefy and flow during firing, which promotes the sintering of the copper-containing particles and adhesion to the substrate, thereby helping promote lower contact resistance and cohesion of the metal particles. Glass frits also enable the paste to fire or pass through a passivation layer, such as a silicon nitride (SiNₓ) passivation layer, below the copper metallization paste and on the surface of the substrate. Glass frits thus will enable the copper metallization paste to pattern the passivation layer during the firing process, eliminating a separate step of patterning the passivation layer and then printing the copper metallization paste into the voids left in the passivation layer from the patterning process. Glass frits may have glass transition temperatures between 300 °C and 900 °C, which enables tuning of the sintering temperature of the copper metallization paste. Various types of glass frits having differing metal oxide compositions may be used in the copper metallization paste, such as lead oxide (PbOₓ), silicon oxide (SiO₂), boron trioxide (B₂O₃), alumina (Al₂O₃), zirconia (ZrO₂), zinc oxide (ZnO),bismuth oxide (Bi₂O₃), strontium oxide (SrO), titanium oxide (TiO₂), and lanthanum oxide (La₂O₃), or combinations thereof.

The metal powder may be dispersed in an organic matrix to from a screen printable paste. The organic matrix includes polymer resins such as ethylcellulose, various chemicals such as solvents (thinners) to tune viscosity characteristics, and surfactants, dispersants, and other additives to help keep the glass frit and metal powder suspended in solution. The additives also improve printing characteristics, and the type of additives will depend on other desired qualities of the final copper metallization paste. The polymer resin may act as a binder to help enable printing of the encapsulated copper-containing particles 210. The polymer resin and other organics are typically removed from the metallization paste after printing and during the firing process by oxidation. For front-side metal pastes, the metal loading is typically 65% to 95% by weight, and the oxide frit is typically between about 0.5% and 10% by weight. The remainder of the metallization paste composition may be the organics package.

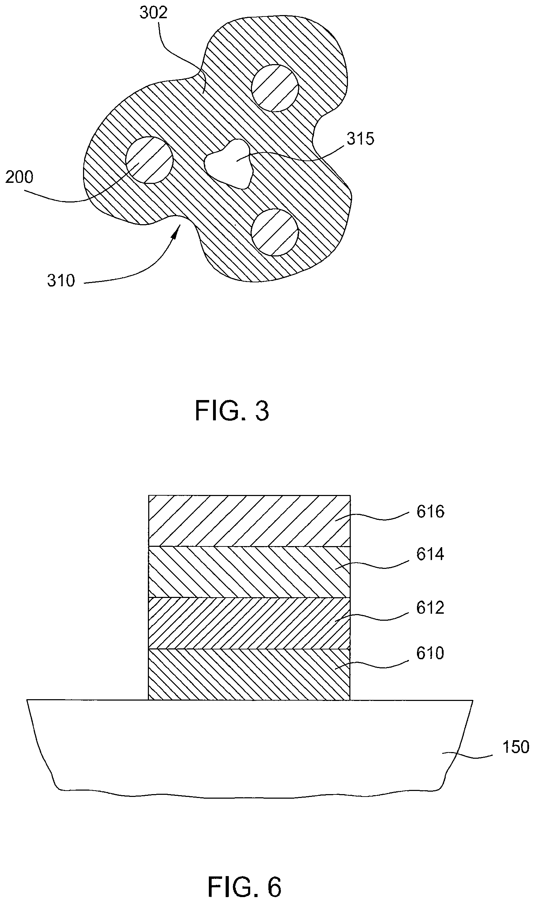

Not wishing to be bound by theory, the outermost layer, such as oxidation barrier layer 202, will primarily participate in the sintering process. Thus, the outermost layer preferably is mobile enough to help densify the particle matrix during the firing and/or sintering cycle to yield a highly conductive layer. Figure 3 illustrates a schematic cross-sectional view of a copper-containing conductive layer matrix during sintering, or in some cases after sintering. In some cases, the elimination of a void, or pore 315, formed between the sintered copper-containing particles 200 is preferred to improve the electrical conductivity of the metal contact structure. The firing process may include a first process to burn off organics and, in some cases, to begin flow of the glass frits in the metallization paste followed by a second temperature spike process. Each portion of the firing process may be done in an oxidizing ambient such as air. The first process temperature may be from 400 °C to 600 °C for around 30 seconds and the second process temperature spike may be around 800 °C for short time periods, such as between about 8 to 12 seconds, for example 10 seconds.

In some embodiments of a solar cell formation process, the contact "firing" step may also include sintering of the metallization paste to form the contact structure 156. Firing is typically a process that causes the metal contacts to make electrical contact with the silicon, and in some cases dope portions of the solar cell substrate to form a desirable junction. The firing process generally creates an ohmic contact between the metal contact structure and the silicon substrate of a solar cell device. Sintering is a process that can be used to densify the metallization powder, an example of which is liquid-phase enhanced sintering associated with particle or powder based metallurgy. Sintering sometimes may be performed as a separate process from firing, but it may also be performed during a firing step when forming solar cell devices.

Liquid-phase enhanced sintering involves a multi-component system where one of the two phases in the system either liquefies or goes above its glass transition temperature, thus making the atoms mobile enough to cause densification of the powdered structure. The outermost layer, e.g. the oxidation barrier layer 202, may be transported between adjacent particles to form a matrix 302 including copper-containing particles 200 and bridges 310. The matrix 302 may also have pores 315. Once the liquid-phase enhanced sintering happens, the matrix 302 has very strong capillary forces that draw particles together. The liquid like material allows enhanced mobility of metal ions to form bridges 310 between metal particles, such as copper-containing particles 200, thereby enhancing the sintering process. The pore volume may almost be zero, and additional particles, such as pure silver particles, may be added to the copper metallization paste to promote the reflow during the sintering process to reduce the pore volume further. The copper-containing particles 200 are joined sufficiently together to provide good conductivity of the sintered contact structure. Other types of metals used in the various barrier layers, such as refractory metals (*e.g*., cobalt based metals) which have a melting point higher than silver, may not move around a lot during the sintering process. Thus, most of the "bridging" created between the copper-containing particles will be due to the movement of the outer oxidation barrier layer 202. In general, the barrier layers should be stable through the firing process, but still allow for the densification through sintering.

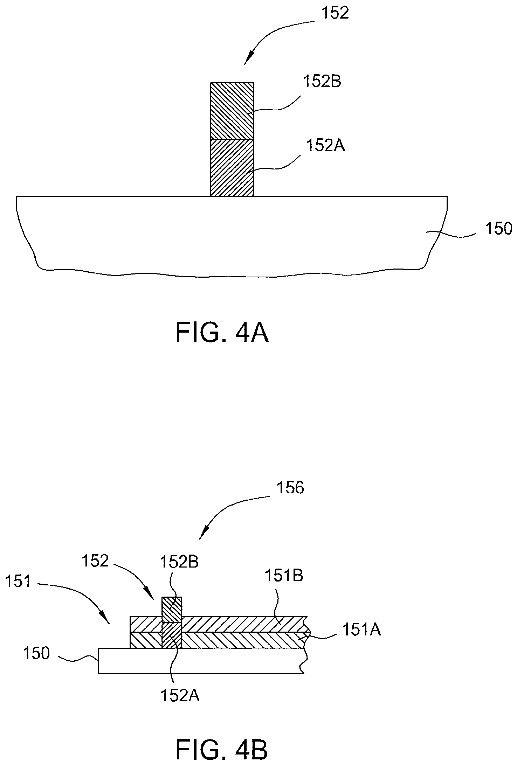

Embodiments of the invention enable various methods of using a copper metallization paste to form contact structures. One method may include using a copper metallization paste in a double-print process. Another method may include using a copper metallization paste as a drop-in replacement for silver metallization pastes. The various processes, methods, and structures, will be explained beginning with the double-print process as shown in Figures 4A-4B.

Figure 4A is a schematic cross-sectional view of a portion of a solar cell substrate having a second layer 152B comprising a copper-containing material printed on a first layer 152A. The first layer 152A provides a contact layer used to form a desirable contact with the solar cell substrate 150. In one example, the first layer 152A can be formed using a silver paste. A silver metallization paste may be used for the first print that is adjacent the solar cell to form the contacting layer. The second printed layer, or the second layer 152B, may comprise a copper metallization paste to form a high conductivity current carrying layer. The copper metallization paste may comprise any one of the encapsulated copper-containing particles 210 described herein.

In an effort to increase the current carrying capacity of the front contact structure 156 without reducing the efficiency of a completed solar cell, the height of the buss bars 151 and fingers 152 may be increased without increasing their width by screen printing the pattern of buss bars 151 and fingers 152 in two or more successive layers. Increasing the height without increasing the width reduces the resistance of the contact structure without increasing the optical losses. Increasing the height of the buss bars 151, however, is optional since it will be contacted with a copper interconnect ribbon during later processing stages. Figure 4B is a schematic side cross-sectional view of a portion of the solar cell substrate 150 having a second layer 151B of buss bars 151 printed on a first layer 151A of buss bars 151 and a second layer 152B of fingers 152 printed on a first layer 152A of fingers 152.

The double print process for the front contact structure 156 includes depositing two layers, *e.g*. two prints, in a pattern for forming the front side contact structure 156 as shown in Figure 1. The double print process enables a narrower grid line width to be used, while maintaining a desired cross-sectional area by use of a higher vertical contact structure aspect ratio to maintain and/or improve the solar cell efficiency. The first and second print process steps may use different pastes and screens (patterns). In one example, the paste for the first print process used to form the first layer 152A is selected for its good electrical contact properties and the paste used to form the second layer 152B is selected for its higher electrical conductivity and ability to be subsequently connected other external devices, *e.g*. other solar cells, external loads, etc.

The first layer 152A, which may contain silver and form a contacting layer with the underlying solar cell substrate 150, also generally provides another layer of protection between the second layer 152B, such as a copper-containing layer, and the solar cell substrate 150 in order to prevent copper migration, diffusion, and subsequent poisoning of the solar cell substrate 150 which may be silicon based. The first layer 152A may have a height or thickness between about 5-15 microns while the second layer 152B may have a height or thickness between about 10-30 microns. The second layer 152B may be built up to provide a desired conductivity, such as 0.05 to 0.3 ohms/cm. The first layer 152A also provides an ohmic contact with the silicon substrate that also forms a desirable bond between the silicon substrate and the first layer 152A. Thus, the same conductivity of silver metallization paste based contact structures may be achieved while reducing the total amount of silver used. Other metals may be used on the gridlines in combination with the copper metallization paste to lower the resistance without implicating costs. Similar methods may be used to form first layer 151A and second layer 151B of buss lines 151.

In some configurations, the first layer 152A may comprise a copper-containing paste. In another configuration, the first layer 152A may comprise a copper-containing paste that has a different barrier layer thickness and/or comprise different barrier layer materials than the second layer 152B. In this configuration, the copper-containing paste in the first layer 152A may provide a good electrical contact to the substrate, while reducing the cost of the first layer 152A over conventional silver pastes and also minimize the chance of copper diffusion into the silicon substrate versus the use of the material composition of second layer 152B in both layers. Thus, first layers 151A, 152A and second layers 151B, 152B may comprise copper metallization pastes that use different types of copper-containing particles in each layer. For example, the first layers may use copper-containing particles surrounded by a first and second barrier layer and the second layer may use copper-containing particles surrounded by a first, second, and third barrier layer, such as those types described previously.

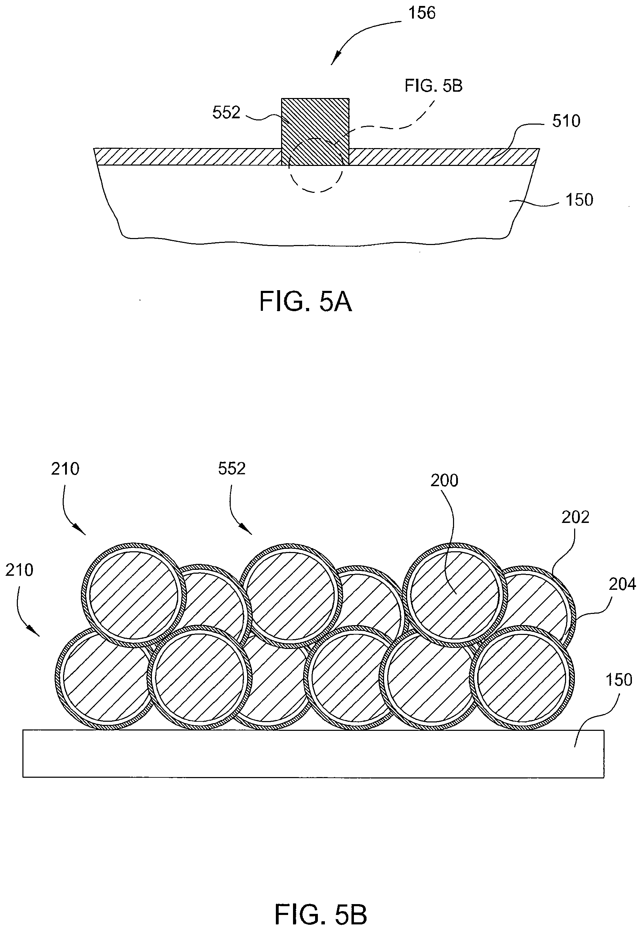

Figures 5A-5B illustrate structures and methods which may include a copper metallization paste as a drop-in replacement for silver metallization pastes. Figure 5A is a schematic cross-sectional view of a portion of a solar cell having a copper layer printed on the silicon substrate. A copper metallization paste is used having similar abilities to silver metallization pastes. A single print is used to pattern and form the copper contact structure using any of the copper metallization pastes described herein. The encapsulated copper-containing particles 210 have a metallization and oxidation barrier coating to survive high-temperature firing. The copper layer 552 forms an ohmic contact with the silicon surface during the firing process. The copper metallization paste may use glass frits for firing through a passivation/ARC layer, such as silicon nitride layer 510, on the surface of the solar cell substrate 150. In some embodiments, silver particles may be included in the copper metallization paste to help inhibit dissolution of the oxidation barrier layer, such as a silver coating on the copper-containing particle, to promote sintering of the metal particles, and to provide a better contacting layer to the silicon cell. Typical print thickness for any of the embodiments described herein, either as an individual layer or a stack of layers, may be from about 1 micron to about 50 microns, such as from about 10 microns to about 30 microns.

Figure 5B is a close up of the copper layer printed on the solar cell substrate 150 as shown in Figure 5A. The copper encapsulated particles shown are the same as those shown in Figure 2B, where the encapsulation layers include an oxidation barrier layer 202 and a metallization barrier layer 204 surrounding the copper-containing particle 200. The encapsulated copper-containing particles 210 are sintered together and provide a conductive layer for the front side contact structure. The copper layer 552 may be built up and sintered to have a certain thickness, such as from 10-40 microns, and to provide a desired bulk resistivity of 1 to 200 µohm-cm, such as from about 2 to 5 µohm-cm. Bulk resistivity is an indication of the degree of metal particle sintering, *i.e.* the resistivity of the fired metallization approaches the resistivity of the bulk metal as the particles achieve greater sintering and density. The gridline may have widths from 50 to 150 microns.

The encapsulated copper-containing particles 210 form an ohmic contact with the substrate 150. Because the copper-containing particle 200 is so close to the silicon surface, a metallization barrier layer 204 may be used and combined with the properties of a diffusion barrier layer as described herein. For example, the oxidation barrier layer 202 may be silver and the metallization barrier layer 204 may be nickel, which also provides the desired diffusion barrier layer properties. The thickness of the layers may be adjusted to accommodate the desired properties and functions of the copper metallization paste. For example, in this particular embodiment, the copper is very close to the substrate surface, giving a shorter diffusion pathway to the silicon. The metallization barrier layer 204 thickness may be increased to provide further protection and prevent out-diffusion of the copper into the silicon substrate 150.

Figure 6 illustrates a schematic cross-sectional view of a copper metallization structure for an ink-jet process. Very small copper-containing particles in the nanometer range with different coatings could be used for ink-jet printing. A metallization barrier layer and oxidation barrier layer may be included on the small ink-jet sized copper-containing particles. Alternatively, the barrier layer could be a separate thin dielectric material rather than a metallic material. For example, the copper-containing particle may be coated with a dielectric material, such as silicate glass, for the barrier layer.

The copper metallization ink formulation may be like a standard ink and may include various constituent components for formulating the desired properties of the copper metallization ink. The constituent components may include metal powder, glass frits, such as those types described herein, additives to modify properties, and an organic, inorganic, or aqueous solvent. Example organic solvents include α-terpineol, toluene, ethanol, etc. The solvent may use multiple chemicals for desired properties; for example, diethylene glycol and water, ethylene glycol and ethanol, etc. An example additive includes polyvinylpyrrolidone (PVP) for prevention of aggregation of the nanoparticles. The metal powder may include encapsulated copper-containing particles described herein, such as the barrier layer using a dielectric material encapsulating the copper-containing particle.

Ink-jet printing may use multiple printing heads with different materials to enable depositing layers in sequential stacks for different functions. Thus, ink-jet printing allows for printing metals with different properties in a stack *i.e.* the stack of metals can be sequentially deposited and optimized for each function. Hence, the ink-jet printing process may include forming a contact layer 610, a metallization barrier layer 612, a copper-containing layer 614 for conductivity, and an oxidation barrier layer 616, all on the substrate 150.

Alternatively, the ink-jet printing structure may comprise various combinations of layers that are deposited with the copper-containing layer 614. For example, only a contact layer 610 with the copper-containing layer 614, a contact layer 610 and an oxidation barrier layer 616 with copper-containing layer 614, or a contact layer 610 and a metallization barrier layer 612 with copper-containing layer 614. The exact combination of layers may depend on the type of encapsulated copper-containing particle 210 used in the copper-containing ink to form copper-containing layer 614. The ink-jet contact structure formation process may include forming the gridlines in desired patterns, which may include stacked layers on top of each other. In some embodiments, separate patterning and passivation layers may be deposited after the metal contact structure is formed.

Some differences between the copper-containing particles used in the copper metallization pastes for printing processes and the copper inks for ink-jet processes may be the particle size, and processing temperatures used to form the contact structure. The copper-containing particles used in the copper metallization pastes may have micron sized copper-containing particle whereas the copper-containing particles used in the copper inks have nanometer sized copper-containing particles. The copper-containing particles for the copper based inks for an ink-jet process may vary in size between 1 and 100 nm. Thus, it may be necessary to stabilize the copper nanoparticles in the copper based ink using various coatings.

The copper-containing particles in the copper ink will densify into dense metal during the sintering process. Thus, a barrier layer for the copper may be provided elsewhere in the stack, such as metallization barrier layer 612 and oxidation barrier layer 616. Dielectrics may be used to encapsulate the nano sized copper-containing particles to stabilize the nano particle in the ink formulation. In other words, the dielectric coating may provide a protective layer for the copper nano particles to survive the ink formulation used to dispense the copper during the ink-jet printing process. The dielectric layer will preferably break up during the sintering process.

Due to the much smaller particle size of the copper-containing particles in the ink-jet process, the sintering temperatures may be much lower. The sintering temperatures may be as low as 150 °C and as high as 400 °C, such as 300 °C, for silicon substrates compared to the sintering temperature, for example 800 °C, for the copper metallization pastes described herein. Thus, the ink-jet process using copper inks having encapsulated copper-containing particles may enable a substantial reduction of the sintering temperatures by 50% or more.

The contact layer 610 may be formed using an ink of Ag, Ni, Ti, W, Al, or other metals that have known contact resistance values to silicon. Other contact layer 610 materials may include transition metal silicides. Glass frits may be included in the ink for the contact layer 610 to pattern previously deposited passivation layers. The metallization barrier layer 612 may include nickel (Ni), titanium (Ti), tungsten (W), titanium-tungsten (TiW), tungsten doped cobalt (Co:W), cobalt (Co), and chromium (Cr), their alloys, or combinations thereof. The metallization barrier layer 612 may also function as an adhesion layer to provide good adhesion between the copper-containing layer 614 and the contact layer 610. Often the metals chosen for various layers in a multiple layered contact structure may be far apart in terms of oxidation potentials, so galvanic corrosion at the interface may occur in a damp-heat environment causing delamination. The metallization barrier layer 612 functioning also as an adhesion layer may thus provide a way to survive damp-heat environments. Alternatively, a separate adhesion layer may also be included in the stack of metal layers 610-616, yielding at least five possible layers from which to form a contact structure. The oxidation barrier layer 616 may include silver (Ag) and tin (Sn). Tin may be preferred as it offers a good solderable connection point. The depths of the various layers may be from 0.01 to 10 microns such as 0.1 microns. The contact structures using copper metallization pastes and inks will need to pass heat and damp-heat tests that solar cell devices undergo for quality control testing and improved solar cell ratings.

While embodiments of the invention have been described using mostly negative-polarity metal (N-type) front contacts for silicon solar cells using p-type substrates and with an n+ doped front surface, it will be apparent to a person of ordinary skill in the art that any use of silver in rear side contact structures for rear side conventional solar cells, rear side contact solar cells, and EWT cells may be replaced with copper using the above methods, processes, and materials. The copper contacts on the rear side that replace the silver contacts may need to be solderable, thus an underlying Ag contacting underlayer for a rear bus bar is not necessary. Similarly, it will also be apparent to a person of ordinary skill in the art that embodiments of the present invention could be used for positive-polarity metal front contacts in silicon solar cells that use n-type substrates with a p+ doped front surface. All types of copper contact structures will need to pass usual qualification tests of thermal cycling, damp-heat testing, and degradation over time. Formulating copper metallization pastes and forming contact structures according to embodiments of the invention will provide reduced manufacturing costs while maintaining if not improving solar cell device life.

## Claims

1. A copper metallization paste, comprising:
an organic matrix;
glass frits within the organic matrix; and
a metal powder within the organic matrix, the metal powder comprising encapsulated copper-containing particles, wherein the encapsulated copper-containing particles each further comprise:
a copper-containing particle; and
at least two coatings of different materials surrounding the copper-containing particle, wherein each coating comprises a material selected from the group consisting of silver (Ag), nickel (Ni), zinc (Zn), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

2. The copper metallization paste of claim 1, wherein the copper-containing particle comprises copper, doped copper, a copper alloy, or combinations thereof.

3. The copper metallization paste of claim 1, wherein the at least two coatings further comprise:
a first barrier layer; and
a second barrier layer, wherein the first barrier layer is an outermost layer and the second barrier layer is located between the first barrier layer and the copper-containing particle.

4. The copper metallization paste of claim 3, wherein the first barrier layer is an oxidation barrier layer and the second barrier layer is at least one of a metallization barrier layer and a diffusion barrier layer.

5. The copper metallization paste of claim 4, wherein the second barrier layer comprises both the metallization barrier layer and the diffusion barrier layer.

6. The copper metallization paste of claim 4, further comprising:
a third barrier layer directly surrounding the copper-containing particle, wherein the second barrier layer is the metallization barrier layer and the third barrier layer is the diffusion barrier layer.

7. The copper metallization paste of claim 4, wherein the oxidation barrier layer comprises silver (Ag), nickel (Ni), and zinc (Zn), their alloys, or combinations thereof;
wherein the metallization barrier layer comprises nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), their alloys, or combinations thereof; and
wherein the diffusion barrier layer comprises nickel (Ni), titanium (Ti), titanium nitride (TiN), transition metal nitrides, transition metal silicide alloys, tungsten (W), titanium-tungsten (TiW), tungsten doped cobalt (Co:W), cobalt (Co), molybdenum (Mo), tantalum (Ta), and chromium (Cr), their alloys, or combinations thereof.

8. A method of forming a contact structure on a solar cell, comprising:
depositing a copper metallization paste on a substrate comprising a doped semiconductor material; and,
heating the copper metallization paste to form a copper layer, wherein the copper metallization paste comprises:
an organic matrix;
glass frits within the organic matrix; and
a metal powder within the organic matrix, the metal powder comprising encapsulated copper-containing particles, wherein at least some of the encapsulated copper-containing particles further comprise:
a copper-containing particle; and
at least two coatings of different materials surrounding the copper-containing particle, wherein each coating comprises a material selected from the group consisting of:
nickel (Ni);
zinc (Zn);
nickel (Ni) and at least one of titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof;
zinc (Zn) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, and transition metal silicide alloys their alloys, or combinations thereof; and
silver (Ag) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

9. The method of claim 8, further comprising:
depositing a contact layer paste on a surface of the substrate;
depositing the copper metallization paste on the contact layer paste; and,
heating the contact layer paste and the copper metallization paste to form a copper layer on a contact layer, wherein the contact layer provides an ohmic contact with the substrate.

10. The method of claim 9, wherein the contact layer paste comprises a copper metallization paste different from the copper metallization paste used to form the copper layer.

11. A solar cell, comprising:
a substrate comprising a doped semiconductor material; and
a front contact structure on a portion of a front surface of the substrate, wherein the front contact structure comprises:
a copper layer comprising sintered encapsulated copper-containing particles, wherein at least some of the encapsulated copper-containing particles further comprise:
a copper-containing particle; and
multiple coatings of different materials surrounding the copper-containing particle, wherein each coating comprises a material selected from the group consisting of:
nickel (Ni);
zinc (Zn);
nickel (Ni) and at least one of titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof;
zinc (Zn) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, and transition metal silicide alloys their alloys, or combinations thereof; and
silver (Ag) and at least one of nickel (Ni), titanium (Ti), titanium nitride (TiN), tungsten (W), titanium-tungsten (TiW), tungsten doped cobalt (Co:W), cobalt (Co), chromium (Cr), molybdenum (Mo), tantalum (Ta), transition metal nitrides, transition metal silicide alloys, their alloys, or combinations thereof.

12. The solar cell of claim 11, wherein the multiple coatings further comprise:
a first barrier layer; and
a second barrier layer, wherein the first barrier layer is an outermost layer and the second barrier layer is located between the first barrier layer and the copper-containing particle.

## Patentansprüche

1. Kupfermetallisierungspaste, umfassend:
eine organische Matrix;
Glasfritten innerhalb der organischen Matrix; und
ein Metallpulver innerhalb der organischen Matrix, wobei das Metallpulver verkapselte kupferhaltige Teilchen umfasst, wobei die verkapselten kupferhaltigen Teilchen jeweils ferner umfassen:
ein kupferhaltiges Teilchen; und
mindestens zwei Beschichtungen aus unterschiedlichen Materialien, die das kupferhaltige Teilchen umgeben, wobei jede Beschichtung ein Material umfasst ausgewählt aus der Gruppe bestehend aus Silber (Ag), Nickel (Ni), Zink (Zn), Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), Übergangsmetallnitride, Übergangsmetallsilicidlegierungen, deren Legierungen oder Kombinationen davon.

2. Kupfermetallisierungspaste nach Anspruch 1, wobei das kupferhaltige Teilchen Kupfer, dotiertes Kupfer, eine Kupferlegierung oder Kombinationen davon umfasst.

3. Kupfermetallisierungspaste nach Anspruch 1, wobei die mindestens zwei Beschichtungen ferner umfassen:
eine erste Barriereschicht; und
eine zweite Barriereschicht, wobei die erste Barriereschicht eine äußerste Schicht ist und die zweite Barriereschicht zwischen der ersten Barriereschicht und dem kupferhaltigen Teilchen angeordnet ist.

4. Kupfermetallisierungspaste nach Anspruch 3, wobei die erste Barriereschicht eine Oxidationsbarriereschicht ist und die zweite Barriereschicht mindestens eines von einer Metallisierungsbarriereschicht und einer Diffusionsbarriereschicht ist.

5. Kupfermetallisierungspaste nach Anspruch 4, wobei die zweite Barriereschicht sowohl die Metallisierungsbarriereschicht als auch die Diffusionsbarriereschicht umfasst.

6. Kupfermetallisierungspaste nach Anspruch 4, ferner umfassend:
eine dritte Barriereschicht, die das kupferhaltige Teilchen direkt umgibt, wobei die zweite Barriereschicht die Metallisierungsbarriereschicht ist und die dritte Barriereschicht die Diffusionsbarriereschicht ist.

7. Kupfermetallisierungspaste nach Anspruch 4, wobei die Oxidationsbarriereschicht Silber (Ag), Nickel (Ni) und Zink (Zn), deren Legierungen oder Kombinationen davon umfasst;
wobei die Metallisierungsbarriereschicht Nickel (Ni), Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), deren Legierungen oder Kombinationen davon umfasst; und
wobei die Diffusionsbarriereschicht Nickel (Ni), Titan (Ti), Titannitrid (TiN), Übergangsmetallnitride, Übergangsmetallsilicidlegierungen, Wolfram (W), Titan-Wolfram (TiW), wolframdotiertes Kobalt (Co:W), Kobalt (Co), Molybdän (Mo), Tantal (Ta) und Chrom (Cr), deren Legierungen oder Kombinationen davon umfasst.

8. Verfahren zum Bilden einer Kontaktstruktur auf einer Solarzelle, umfassend:
Abscheiden einer Kupfermetallisierungspaste auf einem Substrat, das ein dotiertes Halbleitermaterial umfasst; und,
Erhitzen der Kupfermetallisierungspaste, um eine Kupferschicht zu bilden, wobei die Kupfermetallisierungspaste umfasst:
eine organische Matrix;
Glasfritten innerhalb der organischen Matrix; und
ein Metallpulver innerhalb der organischen Matrix, wobei das Metallpulver verkapselte kupferhaltige Teilchen umfasst, wobei mindestens manche der verkapselten kupferhaltigen Teilchen jeweils ferner umfassen:
ein kupferhaltiges Teilchen; und
mindestens zwei Beschichtungen aus unterschiedlichen Materialien, die das kupferhaltige Teilchen umgeben, wobei jede Beschichtung ein Material umfasst ausgewählt aus der Gruppe bestehend aus:
Nickel (Ni);
Zink (Zn);
Nickel (Ni) und mindestens eines von Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), Übergangsmetallnitride, Übergangsmetallsilicidlegierungen, deren Legierungen oder Kombinationen davon;
Zink (Zn) und mindestens eines von Nickel (Ni), Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), Übergangsmetallnitride, Übergangsmetallsilicidlegierungen, deren Legierungen oder Kombinationen davon; und Silber (Ag) und mindestens eines von Nickel (Ni), Titan (Ti), Titannitrid (TiN), Wolfram (W), Titan-Wolfram (TiW), wolframdotiertes Kobalt (Co:W), Kobalt (Cr), Chrom (Cr), Molybdän (Mo), Tantal (Ta), Übergangsmetallnitride, Übergangsmetallsilicidlegierungen, deren Legierungen oder Kombinationen davon.

9. Verfahren nach Anspruch 8, ferner umfassend:
Abscheiden einer Kontaktschichtpaste auf einer Oberfläche des Substrats;
Abscheiden der Kupfermetallisierungspaste auf der Kontaktschichtpaste; und,
Erhitzen der Kontaktschichtpaste und der Kupfermetallisierungspaste, um eine Kupferschicht auf einer Kontaktschicht zu bilden, wobei die Kontaktschicht einen ohmschen Kontakt mit dem Substrat bereitstellt.

10. Verfahren nach Anspruch 9, wobei die Kontaktschichtpaste eine Kupfermetallisierungspaste umfasst, die sich von der Kupfermetallisierungspaste unterscheidet, die verwendet wird, um die Kupferschicht zu bilden.

11. Solarzelle, umfassend:
ein Substrat mit einem dotierten Halbleitermaterial; und
eine vordere Kontaktstruktur auf einem Abschnitt einer Vorderoberfläche des Substrats, wobei die vordere Kontaktstruktur umfasst:
eine Kupferschicht, die gesinterte verkapselte kupferhaltige Teilchen umfasst, wobei mindestens manche der verkapselten kupferhaltigen Teilchen ferner umfassen:
ein kupferhaltiges Teilchen; und
mehrere Beschichtungen aus unterschiedlichen Materialien, die das kupferhaltige Teilchen umgeben, wobei jede Beschichtung ein Material umfasst ausgewählt aus der Gruppe bestehend aus:
Nickel (Ni);
Zink (Zn);
Nickel (Ni) und mindestens eines von Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), Übergangsmetallnitride, Übergangsmetallsilicidlegierungen, deren Legierungen oder Kombinationen davon;
Zink (Zn) und mindestens eines von Nickel (Ni), Titan (Ti), Titannitrid (TiN), Wolfram (W), Titan-Wolfram (TiW), wolframdotiertes Kobalt (Co:W), Kobalt (Co), Chrom (Cr), Molybdän (Mo), Tantal (Ta), Übergangsmetallnitride, Übergangsmetallsilicidlegierungen, deren Legierungen oder Kombinationen davon; und Silber (Ag) und mindestens eines von Nickel (Ni), Titan (Ti), Titannitrid (TiN), Wolfram (W), Titan-Wolfram (TiW), wolframdotiertes Kobalt (Co:W), Kobalt (Cr), Chrom (Cr), Molybdän (Mo), Tantal (Ta), Übergangsmetallnitride, Übergangsmetallsilicidlegierungen, deren Legierungen oder Kombinationen davon.

12. Solarzelle nach Anspruch 11, wobei die mehreren Beschichtungen ferner umfassen:
eine erste Barriereschicht; und
eine zweite Barriereschicht, wobei die erste Barriereschicht eine äußerste Schicht ist und die zweite Barriereschicht zwischen der ersten Barriereschicht und dem kupferhaltigen Teilchen angeordnet ist.

## Revendications

1. Pâte de métallisation au cuivre, comprenant :
une matrice organique ;
des frittes de verre au sein de la matrice organique ; et
une poudre métallique au sein de la matrice organique, la poudre métallique comprenant des particules contenant du cuivre encapsulées, dans laquelle les particules contenant du cuivre encapsulées comprennent chacune en outre :
une particule contenant du cuivre ; et
au moins deux revêtements de matériaux différents entourant la particule contenant du cuivre, dans laquelle chaque revêtement comprend un matériau choisi dans le groupe constitué d'argent (Ag), nickel (Ni), zinc (Zn), titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, alliages de siliciure de métal de transition, leurs alliages, ou des combinaisons de ceux-ci.

2. Pâte de métallisation au cuivre selon la revendication 1, dans laquelle la particule contenant du cuivre comprend du cuivre, du cuivre dopé, un alliage de cuivre, ou des combinaisons de ceux-ci.

3. Pâte de métallisation au cuivre selon la revendication 1, dans laquelle les au moins deux revêtements comprennent en outre :
une première couche barrière ; et
une deuxième couche barrière, dans laquelle la première couche barrière est une couche la plus extérieure et la deuxième couche barrière se situe entre la première couche barrière et la particule contenant du cuivre.

4. Pâte de métallisation au cuivre selon la revendication 3, dans laquelle la première couche barrière est une couche barrière d'oxydation et la deuxième couche barrière est au moins l'une parmi une couche barrière de métallisation et une couche barrière de diffusion.

5. Pâte de métallisation au cuivre selon la revendication 4, dans laquelle la deuxième couche barrière comprend à la fois la couche barrière de métallisation et la couche barrière de diffusion.

6. Pâte de métallisation au cuivre selon la revendication 4, comprenant en outre :
une troisième couche barrière entourant directement la particule contenant du cuivre, dans laquelle la deuxième couche barrière est la couche barrière de métallisation et la troisième couche barrière est la couche barrière de diffusion.

7. Pâte de métallisation au cuivre selon la revendication 4, dans laquelle la couche barrière d'oxydation comprend de l'argent (Ag), du nickel (Ni) et du zinc (Zn), leurs alliages, ou des combinaisons de ceux-ci ;
dans laquelle la couche barrière de métallisation comprend du nickel (Ni), du titane (Ti), du nitrure de titane (TiN), du tungstène (W), du titane-tungstène (TiW), du cobalt dopé au tungstène (Co:W), du cobalt (Co), du chrome (Cr), du molybdène (Mo), du tantale (Ta), leurs alliages, ou des combinaisons de ceux-ci ; et
dans laquelle la couche barrière de diffusion comprend du nickel (Ni), du titane (Ti), du nitrure de titane (TiN), des nitrures de métal de transition, des alliages de siliciure de métal de transition, du tungstène (W), du titane-tungstène (TiW), du cobalt dopé au tungstène (Co:W), du cobalt (Co), du molybdène (Mo), du tantale (Ta) et du chrome (Cr), leurs alliages, ou des combinaisons de ceux-ci.

8. Procédé de formation d'une structure de contact sur une cellule solaire, comprenant :
le dépôt d'une pâte de métallisation au cuivre sur un substrat comprenant un matériau semi-conducteur dopé ; et,
le chauffage de la pâte de métallisation au cuivre pour former une couche de cuivre, dans lequel la pâte de métallisation au cuivre comprend :
une matrice organique ;
des frittes de verre au sein de la matrice organique ; et
une poudre métallique au sein de la matrice organique, la poudre métallique comprenant des particules contenant du cuivre encapsulées, dans laquelle au moins certaines des particules contenant du cuivre encapsulées comprennent chacune en outre :
une particule contenant du cuivre ; et
au moins deux revêtements de matériaux différents entourant la particule contenant du cuivre, dans lequel chaque revêtement comprend un matériau choisi dans le groupe constitué de :
nickel (Ni) ;
zinc (Zn) ;
nickel (Ni) et au moins l'un parmi titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, alliages de siliciure de métal de transition, leurs alliages, ou des combinaisons de ceux-ci ;
zinc (Zn) et au moins l'un parmi nickel (Ni), titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, et alliages de siliciure de métal de transition, leurs alliages, ou des combinaisons de ceux-ci ; et argent (Ag) et au moins l'un parmi nickel (Ni), titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, alliages de siliciure de métal de transition, leurs alliages, ou des combinaisons de ceux-ci.

9. Procédé selon la revendication 8, comprenant en outre :
le dépôt d'une pâte de couche de contact sur une surface du substrat ;
le dépôt de la pâte de métallisation au cuivre sur la pâte de couche de contact ; et,
le chauffage de la pâte de couche de contact et de la pâte de métallisation au cuivre pour former une couche de cuivre sur une couche de contact, dans lequel la couche de contact fournit un contact ohmique avec le substrat.

10. Procédé selon la revendication 9, dans lequel la pâte de couche de contact comprend une pâte de métallisation au cuivre différente de la pâte de métallisation au cuivre utilisée pour former la couche de cuivre.

11. Cellule solaire, comprenant :
un substrat comprenant un matériau semi-conducteur dopé ; et
une structure de contact avant sur une partie d'une surface avant du substrat, dans laquelle la structure de contact avant comprend :
une couche de cuivre comprenant des particules contenant du cuivre encapsulées frittées, dans laquelle au moins certaines des particules contenant du cuivre encapsulées comprennent en outre :
une particule contenant du cuivre ; et
de multiples revêtements de matériaux différents entourant la particule contenant du cuivre, dans laquelle chaque revêtement comprend un matériau choisi dans le groupe constitué de :
nickel (Ni) ;
zinc (Zn) ;
nickel (Ni) et au moins l'un parmi titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, alliages de siliciure de métal de transition, leurs alliages, ou des combinaisons de ceux-ci ;
zinc (Zn) et au moins l'un parmi nickel (Ni), titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, et alliages de siliciure de métal de transition, leurs alliages, ou des combinaisons de ceux-ci ; et argent (Ag) et au moins l'un parmi nickel (Ni), titane (Ti), nitrure de titane (TiN), tungstène (W), titane-tungstène (TiW), cobalt dopé au tungstène (Co:W), cobalt (Co), chrome (Cr), molybdène (Mo), tantale (Ta), nitrures de métal de transition, alliages de siliciure de métal de transition, leurs alliages, ou des combinaisons de ceux-ci.

12. Cellule solaire selon la revendication 11, dans laquelle les multiples revêtements comprennent en outre :
une première couche barrière ; et
une deuxième couche barrière, dans laquelle la première couche barrière est une couche la plus extérieure et la deuxième couche barrière se situe entre la première couche barrière et la particule contenant du cuivre.
